# EUROPEAN PATENT APPLICATION

(11) **EP 2 273 557 A2**
(43) Date of publication of application: **12.01.2011**
(21) Application number: 10425234.1
(22) Date of filing: 09.07.2010
(51) Int. Cl.: H01L 31/04

(54) **Power supply photovoltaic module system and related photovoltaic module**

(30) Priority: 09.07.2009 IT RM20090352
(71) Applicant: BITRON S.p.A., 10122 Torino (IT)
(72) Inventor: Promutico, Fabrizio, 10122 Torino (IT)
(74) Representative: Iannone, Carlo Luigi

(57) **Abstract**

The present invention relates to a supply photovoltaic modular system (1) comprising a support structure (8), photovoltaic means suitable to convert solar energy into electric power, and a load, such as a lamp (9) or like, electrically connected with said photovoltaic means, to be supplied by the latter, **characterised in that** said photovoltaic means comprise one or more photovoltaic modules (1; 1a), each one having a through channel (C), said photovoltaic modules (1; 1a) being stacked in said support structure (8).

The present invention also relates to a photovoltaic module (1; 1a).

## Description

The present invention relates to a modular supply photovoltaic system, and to a relevant photovoltaic module.

More specifically, the invention relates to a supply system, and particularly a modular lamp, provided with compact and highly efficient modules, that can be easily transported and installed in every situation requiring supplying an apparatus located where electric supply network does not arrive.

In the following the specification will be addressed to a street lamp, but it is well evident that the same must not be considered limited to this specific use.

As it is well known, always more used are supply systems using renewable energy. Among the most diffused renewable energy supplies it is surely included solar energy, for the exploitation of which solar cells or photovoltaic cells have been developed. The latter are comprised of a plurality of modules, provided side by side each other, with a flat surface picking up sun light.

Said modules, also known as photovoltaic modules, can be realised by employing different technologies, mainly individuated by basic material employed for realising them, such as monocrystalline silicon, polycrystalline silicon, or amorphous silicon, just to mention the most diffused.

It must also taken into consideration that solar cells are used both for realising large supply systems, and for supplying small elements, for supplying reduced charges, such as lamps and logic devices. One of the technical problems of solar cells when applied to small elements is due to the fact that they are aesthetically unpleasant, and thus they cannot be often used where aesthetic constraint must be fulfilled.

Furthermore, solar cells must be oriented to work properly. However, even individuating an optimum orientation, said solar cells cannot have a uniform efficiency all during the day, due to the earth rotation with respect to the sun.

Finally, the above flat shape of solar cells causes the so called "sail effect", so that the same are partially subjected to strong stresses by the wind, which often can also damage them.

Photovoltaic cells are known having modules provided along a cylindrical surface, such as those described in GB patent application n° 2408395. Said solar cells, even not requiring an orientation and being able overcoming the above "wing effect" problem, in any case are characterised by installation problems.

It must be taken into consideration that lamps provided with a photovoltaic technology on their lateral surface available on the market are very cumbersome to be installed. Therfore, they can be easily subjected to damages, due to wind or any other outer stress.

In view of the above, it is therefore object of the present invention that of suggesting a lamp that can be easily installed and is not subjected to risks by outer stresses.

It is further object of the present invention that of suggesting a photovoltaic module overcoming all the above mentioned technical problems, also permitting a high energetic efficiency.

It is therefore specific object of the present invention a supply photovoltaic modular system comprising a support structure, photovoltaic means suitable to convert solar energy into electric power, and a load, such as a lamp or like, electrically connected with said photovoltaic means, to be supplied by the latter, **characterised in that** said photovoltaic means comprise one or more photovoltaic modules, each one having a through channel, said photovoltaic modules being stacked in said support structure.

Always according to the invention, said support structure has a first portion and a second portion, said second portion having a cross section lower than said first portion, said photovoltaic modules being stackable on said second portion, said second portion of said support structure passing through the channel of each one of said one or more photovoltaic modules.

Still according to the invention, said support structure is a pole or like.

Furthermore, according to the invention, said photovoltaic modules have a circular or a regular or irregular polygonal cross section.

Advantageously according to the invention, said through channel has cross section equal to the cross section of said second portion of said support structure.

Always according to the invention, each one of said photovoltaic modules comprises a frame, having a lateral outer surface, and a plurality of photovoltaic panels to convert solar energy into electric energy, placed side by side each other, each photovoltaic panel being coupled with said outer surface of said frame.

Still according to the invention, said frame has a prismatic shape, with a polygonal base, preferably a hexagonal base, said lateral outer surface having a plurality of flat lateral faces, on each one of which a photovoltaic panel is provided.

Advantageously according to the invention, said system comprises a first and a second base supports, substantially faced each other, each base support having a hole and being suitable to keep coupled said flat photovoltaic panels with said frame.

Furthermore according to the invention, each one of said photovoltaic modules comprises a first and a second base support, placed substantially faced each other, and a plurality of photovoltaic bars to convert solar energy into electric energy, each one having a first and a second end, said first end of each one of said photovoltaic bars being fixed to a surface of said first base support and said second end of each one of said photovoltaic bars being fixed to a surface of said second base support.

Always according to the invention, said system comprises a first outer cover, preferably a texturized cover, limiting exit of entered and/or reflected light from within said module.

Still according to the invention, said photovoltaic bars are provided along a circle between said first and second base support, so that said module has a substantially cylindrical shape, said first and second base supports have each one a substantially central hole, and in that it comprises a second inner cover, placed so that said photovoltaic bars are provided between the same and said first outer cover.

Furthermore according to the invention, said second inner cover has its surface faced toward said first outer cover reflecting and/or operated by extrusion, so as to increase inner reflection and diffusion of light entered within said photovoltaic module and not intercepted by said photovoltaic bars, thus increasing efficiency of module.

Advantageously according to the invention said system comprises one or more accumulators connected with each photovoltaic panel and an aeolic generator installed on said support structure, suitable to supply and/or integrate supplying of said load delivered by said one or more photovoltaic modules.

It is further object of the present invention a photovoltaic module having a through channel and a circular or regular or irregular polygonal cross section.

Always according to the invention, said module can comprise a frame, having a lateral outer surface, and a plurality of photovoltaic modules for converting solar energy into electric energy, placed side by side, each photovoltaic panel being coupled with said outer surface of said frame.

Still according to the invention, said frame can have a prismatic shape with a polygonal base, preferably a hexagonal base, said lateral outer surface being comprised of a plurality of flat lateral faces, each photovoltaic panel being provided on a relevant one of said flat lateral faces of said frame, and it can comprise a first and a second base supports, substantially faced each other, each base support having a hole and being suitable to keep coupled said flat photovoltaic panels with said frame.

Furthermore, according to the invention, said module can comprise a first and a second base support, placed substantially faced each other, and a plurality of photovoltaic bars to convert solar energy into electric energy, each one having a first and a second end, said first end of each one of said photovoltaic bars being fixed to a surface of said first base support and said second end of each one of said photovoltaic bars being fixed to a surface of said second base support.

Advantageously, according to the invention, said module can comprise a first outer cover, preferably a texturized cover, limiting exit of entered and/or reflected light from within said module, and said photovoltaic bars can be provided along a circle between said first and second base support, so that said module has a substantially cylindrical shape, and it can comprises a second inner cover, placed so that said photovoltaic bars are provided between the same and said first outer cover.

Always according to the invention, 1 said second inner cover can have its surface faced toward said first outer cover reflecting and/or operated by extrusion, so as to increase inner reflection and diffusion of light entered within said photovoltaic module and not intercepted by said photovoltaic bars, thus increasing efficiency of module.

The present invention will be now described, for illustrative, but not limitative, purposes, according to its preferred embodiments, with particular reference to the enclosed drawings, wherein:
figure 1 shows a lateral view of a first embodiment of a photovoltaic module according to the present invention;
figure 2 is an exploded view of module of figure 1;
figure 3 is a view taken along line A-A of module of figure 1;
figure 4 shows a lamp according to the present invention realised by photovoltaic module of figure 1;
figure 5 is an exploded view of lamp of figure 4;
figures 6 shows a perspective view of a second embodiment of a photovoltaic module according to the present invention;
figure 7 is an exploded view of module of figure 6;
figure 8 is a second exploded view of module of figure 6;
figure 9 shows a lamp according to the present invention realised by photovoltaic module of figure 6 partially installed; and
figure 10 shows lamp of figure 9 with a plurality of modules installed.

The same references will be used in the different figures to indicate similar parts.

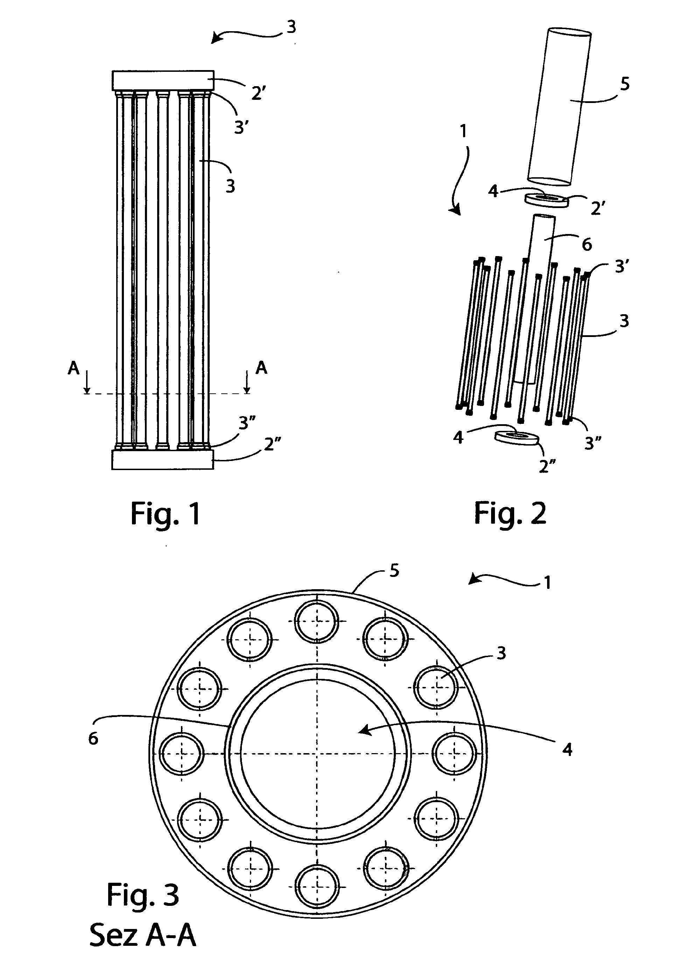

Making reference to figures 1 - 3, it is observed a first embodiment of a photovoltaic module 1 according to the present invention.

Said photovoltaic module 1 comprises a first and a second base supports, and a plurality of photovoltaic bars 3, each one of said photovoltaic bars 3 has a first end 3' fixed to said first base support 2' and a second end fixed to said second base support 2".

Each photovoltaic bar 3 can convert solar or light energy, intercepted by surface, into electric power.

Said photovoltaic bars 3 are fixed substantially along the perimeter of said support bases 2', 2", so that photovoltaic module 1 has a substantially cylindrical shape.

Said base supports 2' and 2" have a hole, substantially in a central position, permitting simplifying installation of photovoltaic module 1, as it will be better described in the following.

Said photovoltaic module 1 also comprises a first outer cover 5 and a second inner cover 6. Said first outer cover 5 is comprised of material making light passing and preferably texturized, so as to limit outlet of light entered within photovoltaic module 1 and/or innerly reflected within the same.

Said second inner cover 6 is so placed that photovoltaic bars 1 are placed between the same and said first outer cover 5. Furthermore, surface of said second inner cover 6 faced on said first outer cover 5 is a reflecting surface and/or a surface obtained by extrusion.

Said first outer cover 5 and said second inner cover 6 permit both protecting bars 3, for example from outer atmospheric agents and like, or from shocks, and preventing light entering within the photovoltaic module can exit from the same. In fact, said covers 5, 6 cause multiple inner reflections between the same covers 5 and 6, thus remarkably increasing energetic efficiency.

As it can be observed, photovoltaic module 1 has a substantially tubular final shape, with an inner C-shaped through channel along symmetry axis of the same module 1, permitting a high installation versatility under different conditions, e.g. a power production tower or installed within lighting elements, as it will be described in the following.

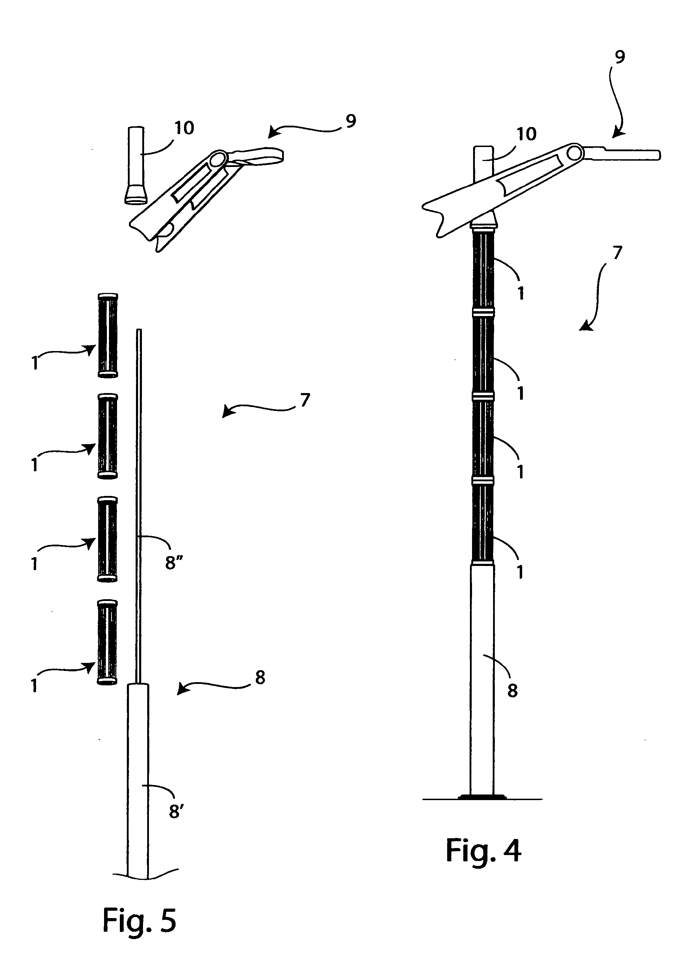

Figures 4 and 5 shows a lamp 7 provided with photovoltaic modules 1 according to the present invention.

Said lamp 7 mainly comprises a support structure, in the described embodiment a pole 8 having a first lower portion 8' and a second upper portion 8", the latter having a cross section lower than the cross section of said first lower portion 8'.

Lamp 7 comprises a plurality of photovoltaic modules 1, inserted along said second upper portion 8", inserting the latter within said holes 4 of said module 1 basis.

Diameter of the cross section of said photovoltaic modules 1 is substantially the same of diameter of cross section of said first lower portion 8' of said pole 8, so as to aesthetically improve lamp 7.

Further, said lamp 7 also comprises a lighting lamp 9 installed in the present embodiment on the upper end of said pole 8 and electrically connected with said photovoltaic modules for electric supply.

Finally, said lamp 7 can preferably provide an aeolic generator 10, installed on the upper end of said pole 8, suitable to supply and/or integrate supplying of said lamp 9 delivered by said photovoltaic modules 1.

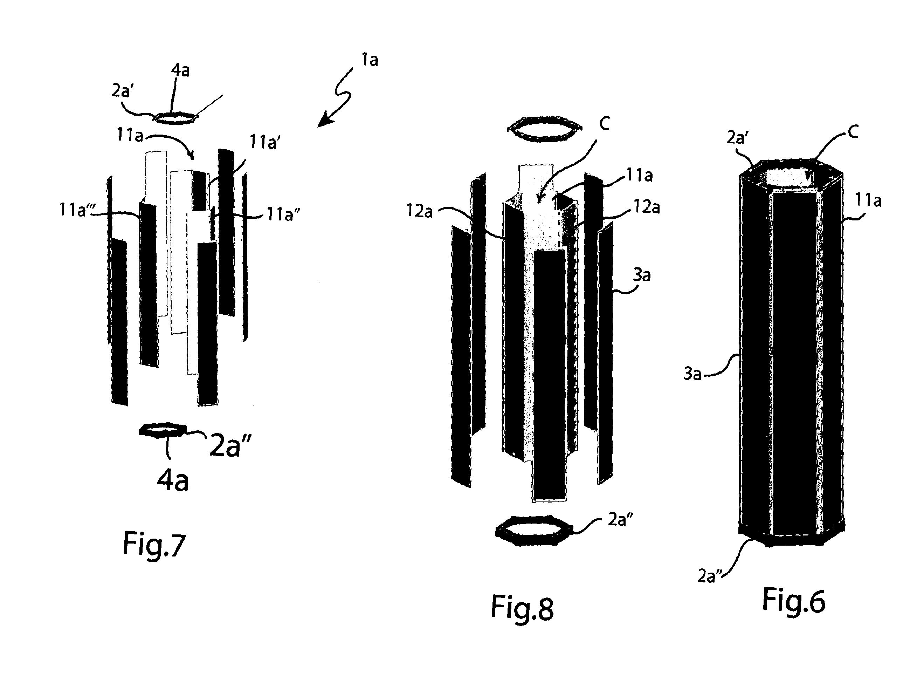

Making now reference to figures 6 and 7, it is possible observing a second embodiment of a photovoltaic 1a according to the present invention.

Said photovoltaic module 1 a comprises a first and a second base support, respectively 2a' and 2a", each one having a substantially central hole. Said module 1 a also comprises a frame 11a, comprised of three elements 11a', 11a" and 11a"', connected each other. Said frame 11 a has a prism shape with a hexagonal base.

Six flat photovoltaic panels 3a are fixed on each one of the six flat lateral faces 12a or support walls, of the frame, each one covering lateral surface of prism realised by frame 11 a.

Base supports 2a' and 2a" are suitable to keep coupled each photovoltaic panel 3a to the relevant flat lateral face 12a of frame 11a, as well as to maintain all together three elements 11a', 11a" and 11a"' of frame 11a.

As to photovoltaic module 1, also photovoltaic module 1 a has a through channel C within frame 11a. Said through channel C is substantially placed along symmetry axis of each photovoltaic module 1 a.

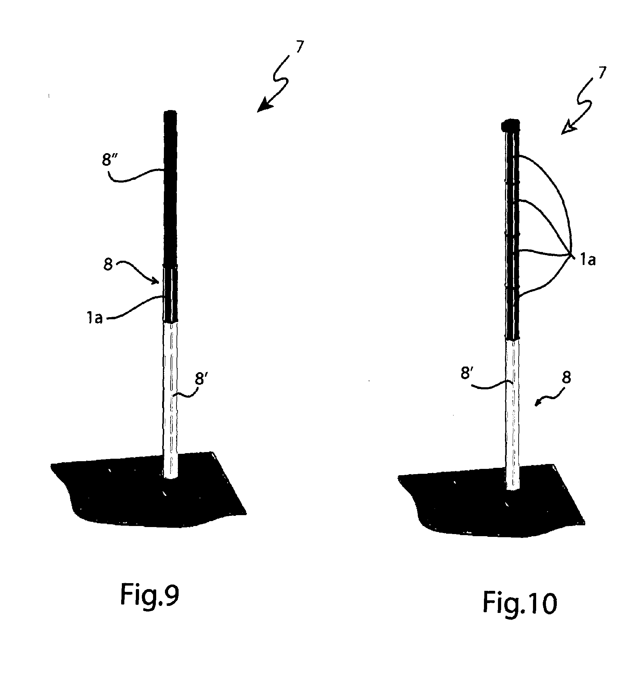

Figures 9 and 10 show a lamp 7 according to the present invention provided with photovoltaic modules 1 a.

Said lamp 7 comprises a pole 8 with a first lower portion 8' and a second upper portion 8", the latter having a lower section of said first lower portion 8'.

A plurality of photovoltaic modules 1a are stacked along said second upper portion 8". Said second upper portion 8" of said pole 8 passes through said holes 4 of said base supports 2a' and 2a", and along channel C, each one provided with said modules 1 a.

Obviously, in this case diameter of each module 1a has a section corresponding to the section of the pole 8 lower portion 8'.

Obviously, photovoltaic modules 1 or 1 a can have every type of cross section, such as circular, regular or irregular polygonal. Instead, inner channel C has a cross section corresponding to the cross section of the pole 8 second upper portion 8".

Under an electrical point of view, lamp 7 according to the present invention has one or more batteries, to which photovoltaic modules 1 or 11 a are connected. Each photovoltaic module 1 or 1a is functionally and electrically independent from others. Therefore, in case of failure of one of them, other modules can still operate charging batteries and thus supplying lamp, only feeling a light power reduction.

Obviously, supply system according to the invention can be also realised, beyond as a lamp, as a pole for supplying different devices, for example street detection devices.

Main advantages of the present invention are the following:
- tubular and/or cylindrical and/or polygonal shape of the photovoltaic module permits limiting "wing effect" and avoiding needing of orienteering the same module;
- described structure of said photovoltaic module, thanks to inner reflections, permits obtaining a high efficiency.

A further advantage of the present invention is that it is possible capturing also light reflected within the same photovoltaic module.

The present invention has been described for illustrative, but not limitative purposes, according to its preferred embodiments, but it is to be understood that variations and/or modifications can be introduced by those skilled in the art without departing from the relevant scope as defined in the enclosed claims.

## Claims

1. Supply photovoltaic modular system (1) comprising a support structure (8),
photovoltaic means suitable to convert solar energy into electric power, and
a load, such as a lamp (9) or like, electrically connected with said photovoltaic means, to be supplied by the latter,
**characterised in that**
said photovoltaic means comprise one or more photovoltaic modules (1; 1 a), each one having a through channel (C), said photovoltaic modules (1; 1 a) being stacked in said support structure (8).

2. System (7) according to claim 1, **characterised in that** said support structure (8) has a first portion (8') and a second portion (8"), said second portion (8") having a cross section lower than said first portion (8'), said photovoltaic modules (1; 1 a) being stackable on said second portion (2), said second portion (8") of said support structure (8) passing through the channel (C) of each one of said one or more photovoltaic modules (1; 1a).

3. System (7) according to each one of preceding claims, **characterised in that** said support structure is a pole or like (8).

4. System (7) according to each one of preceding claims, **characterised in that** said photovoltaic modules (1; 1 a) has a circular or a regular or irregular polygonal cross section.

5. System (7) according to each one of preceding claims, **characterised in that** said through channel (C) has cross section equal to the cross section of said second portion (") of said support structure (8).

6. System (7) according to each one of preceding claims, **characterised in that** each one of said photovoltaic modules (1a) comprises
a frame (11a), having a lateral outer surface, and
a plurality of photovoltaic panels (3a) to convert solar energy into electric energy, placed side by side each other, each photovoltaic panel (3a) being coupled with said outer surface of said frame (11a).

7. System (7) according to claim 6, **characterised in that** said frame (11a) has a prismatic shape, with a polygonal base, preferably a hexagonal base, said lateral outer surface having a plurality of flat lateral faces (12a), on each one of which a photovoltaic panel (3a) is provided.

8. System (7) according to each one of preceding claims 6 or 7, **characterised in that** it comprises a first (2a') and a second (2a") base supports, substantially faced each other, each base support (2a'; 2a") having a hole (4a) and being suitable to keep coupled said flat photovoltaic panels (3a) with said frame (11a).

9. System (7) according to each one of preceding claims 1 - 5, **characterised in that** each one of said photovoltaic modules (1a) comprises
a first (2') and a second (2") base support, placed substantially faced each other, and
a plurality of photovoltaic bars (3) to convert solar energy into electric energy, each one having a first (3') and a second (3") end, said first end (3') of each one of said photovoltaic bars (1) being fixed to a surface of said first base support (2') and said second end (3") of each one of said photovoltaic bars (3) being fixed to a surface of said second base support (2").

10. System (7) according to claim 6, **characterised in that** it comprises a first outer cover (5), preferably a texturized cover, limiting exit of entered and/or reflected light from within said module (1).

11. System (7) according to each one of preceding claims 9 or 10, **characterised in that**
said photovoltaic bars are provided along a circle between said first and second base support (2', 2"), so that said module (1) has a substantially cylindrical shape,
said first and second base supports (2', 2") have each one a substantially central hole (4),
and **in that** it comprises a second inner cover (6), placed so that said photovoltaic bars (3) are provided between the same and said first outer cover (5).

12. System (7) according to claim 11, **characterised in that** said second inner cover (6) has its surface faced toward said first outer cover (5) reflecting and/or operated by extrusion, so as to increase inner reflection and diffusion of light entered within said photovoltaic module (1) and not intercepted by said photovoltaic bars (3), thus increasing efficiency of module (1).

13. System (7) according to each one of preceding claims, **characterised in that** it comprises one or more accumulators connected with each photovoltaic panel (1; 1a) and an aeolic generator (10) installed on said support structure (8), suitable to supply and/or integrate supplying of said load delivered by said one or more photovoltaic modules (1; 1 a).

14. Photovoltaic module (1; a1) having a through channel (C) and a circular or regular or irregular polygonal cross section.

15. Photovoltaic module (1a) according to claim 14, **characterised in that** it comprises a frame (11a), having a lateral outer surface, and a plurality of photovoltaic modules (3a) for converting solar energy into electric energy, placed side by side, each photovoltaic panel (3a) being coupled with said outer surface of said frame (11a).

16. Photovoltaic module (1a) according to claim 15, **characterised in that**
said frame has a prismatic shape with a polygonal base, preferably a hexagonal base, said lateral outer surface being comprised of a plurality of flat lateral faces (12a),
each photovoltaic panel (3a) being provided on a relevant one of said flat lateral faces (12a) of said frame (11a),
and **in that** it comprises a first (2a') and a second (2a") base supports, substantially faced each other, each base support (2a'; 2a") having a hole (4a) and being suitable to keep coupled said flat photovoltaic panels (3a) with said frame (11a).

17. Photovoltaic module (1a) according to claim 14, **characterised in that** it comprises
a first (2') and a second (2") base support, placed substantially faced each other, and
a plurality of photovoltaic bars (3) to convert solar energy into electric energy, each one having a first (3') and a second (3") end, said first end (3') of each one of said photovoltaic bars (1) being fixed to a surface of said first base support (2') and said second end (3") of each one of said photovoltaic bars (3) being fixed to a surface of said second base support (2").

18. Photovoltaic module (1a) according to claim 17, **characterised in that**
it comprises a first outer cover (5), preferably a texturized cover, limiting exit of entered and/or reflected light from within said module (1),
and **in that** said photovoltaic bars are provided along a circle between said first and second base support (2', 2"), so that said module (1) has a substantially cylindrical shape,
and **in that** it comprises a second inner cover (6), placed so that said photovoltaic bars (3) are provided between the same and said first outer cover (5).

19. Photovoltaic module (1a) according to claim 18, **characterised in that** said second inner cover (6) has its surface faced toward said first outer cover (5) reflecting and/or operated by extrusion, so as to increase inner reflection and diffusion of light entered within said photovoltaic module (1) and not intercepted by said photovoltaic bars (3), thus increasing efficiency of module (1).
